(19) Europäisches Patentamt
European Patent Office
Office européen des brevets

(11) **EP 2 921 850 B1**

(12) **EUROPEAN PATENT SPECIFICATION**

(45) Date of publication and mention
of the grant of the patent:
**20.06.2018 Bulletin 2018/25**

(51) Int Cl.:
***G01N 27/12*** *(2006.01)*        ***G01R 15/00*** *(2006.01)*

(21) Application number: **14001001.8**

(22) Date of filing: **18.03.2014**

(54) **Read-out circuit for resistive sensor**

Ausleseschaltung für Widerstandssensor

Circuit de lecture de capteur résistif

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**23.09.2015 Bulletin 2015/39**

(73) Proprietor: **Sensirion AG**
**8712 Stäfa (CH)**

(72) Inventors:
• **Banjevic, Mirjana**
**8712 Stäfa (CH)**
• **Steiner Vanha, Ralph**
**8712 Stäfa (CH)**
• **Wang, Zhenhua**
**8712 Stäfa (CH)**

(74) Representative: **Mirza, Akram Karim et al**
**E. Blum & Co. AG**
**Vorderberg 11**
**8044 Zürich (CH)**

(56) References cited:
**GB-A- 2 059 602     US-B1- 7 310 656**

• **DIEGO BARRETTINO ET AL: "A Smart
Single-Chip Micro-Hotplate-Based Gas Sensor
System in CMOS-Technology", ANALOG
INTEGRATED CIRCUITS AND SIGNAL
PROCESSING, KLUWER ACADEMIC
PUBLISHERS, BO, vol. 39, no. 3, 1 June 2004
(2004-06-01), pages 275-287, XP019203926, ISSN:
1573-1979, DOI:
10.1023/B:ALOG.0000029663.89451.A0**
• **D. BARRETTINO ET AL: "A smart single-chip
micro-hotplate-based chemical sensor system in
CMOS-technology", 2002 IEEE INTERNATIONAL
SYMPOSIUM ON CIRCUITS AND SYSTEMS.
PROCEEDINGS (CAT. NO.02CH37353), 1 January
2002 (2002-01-01), pages II-157, XP055122602,
DOI: 10.1109/ISCAS.2002.1010948 ISBN:
978-0-78-037448-5**
• **BARRENINO D ET AL: "Hotplate-based
conductometric monolithic cmos gas sensor
system", 2003 SYMPOSIUM ON VLSI CIRCUITS.
DIGEST OF TECHNICAL PAPERS. KYOTO,
JAPAN, JUNE 12 - 14, 2003; [SYMPOSIUM ON
VLSI CIRCUITS], NEW YORK, NY : IEEE, US, 12
June 2003 (2003-06-12), pages 157-160,
XP010651104, DOI: 10.1109/VLSIC.2003.1221188
ISBN: 978-4-89114-034-2**

**Description**

FIELD OF THE INVENTION

The present invention relates a read-out circuit for a resistive sensor, particularly for metal oxide based chemical sensor.

BACKGROUND OF THE INVENTION

Examples of monolithic gas sensor microsystems defined as having on-chip sensing device, drivers, controllers and read-out circuitry on a single chip or substrate are described, for instance, among other things in M. Graf et. al. "Metal Oxide Monolithic Complementary Oxide Semiconductor Gas Sensor Microsystem", Anal. Chem., 2004,4437-4445 and in U. Frey et al. " A Digital CMOS Architecture for a Micro-Hotplate Array", IEEE Journal of Solid State Circuits, 42, no.2, Feb. 2007, 441-450.

Translinear circuits are known as such and generally characterized through the use of elements exhibiting an exponential current-voltage relations. Such relations are found for example in diodes and bipolar junction transistors (BJTs) or more complex circuits built with diodes and bipolar junction transistors (BJTs). Translinear characteristics are used in logarithmic (log) circuits. Examples used for the reading-out of photodiodes using log amps are described for example in the United States patent no. 7310656. The '656 document describes further compensation circuits, e.g., for temperature compensation or junction behavior. Other logarithmic circuits are described in the United States patents 4604532, 5677561, and 8207776.

Log amps are commercially available, for example as LOG114 from Texas Instruments (see datasheet SBOS301A - May 2004 - REVISED MARCH 2007)

Resistive sensors, particularly metal oxides, have typically a very large dynamic range often requiring an accurate read-out of resistance values between 10kΩ to tens of GΩ. The presence of an on-chip heat source generating local temperatures changes of hundreds of Kelvin in a least part of the chip poses an additional particular challenge to temperature compensation for any read-out circuit.

In "A Smart Single-Chip Micro-Hotplate-Based Gas Sensor System in CMOS-Technology", DIEGO BARRETTINO ET AL, ANALOG INTEGRATED CIRCUITS AND SIGNAL PROCESSING, KLUWER ACADEMIC PUBLISHERS, BO, vol. 39, no. 3, 1 June 2004 (2004-06-01), pages 275-287, XP019203926, ISSN: 1573-1979, DOI: 10.1023/B:ALOG.0000029663.89451.A0,a monolithic chemical gas sensor fabricated in industrial CMOS technology combined with post-CMOS processing is described. The disclosed system comprises metal-oxide covered ($SnO_2$) micro-hotplates and the necessary driving and signal-conditioning circuitry. Furthermore a logarithmic converter was included to measuring the $SnO_2$ resistance variation upon gas exposure over a range of four orders of magnitude between 1kΩ and 10MΩ.

SUMMARY OF THE INVENTION

Hence, according to a first aspect of the invention, there is provided a circuit with a resistive sensing element whose terminals are connected to a sensing voltage VS, and a reference resistive element whose terminals are connected to a reference voltage, VR. One terminal of each resistor is connected to the input of a translinear current-to-voltage (I-V) converter configured such that the difference of the output of the converters is proportional to the logarithm of the resistance of the resistive sensing element scaled by the resistance of the resistive reference element.

A translinear I-V converter is a converter the output of which is a non-linear compressed voltage response to the input current. A preferred example of such a convertor is a logarithmic amplifier, in particular a logarithmic amplifier with a bipolar npn-transistor (BJT) as a non-linear element.

The converter is best stabilized through a feedback loop, preferably through a capacitance or a capacitance and a resistor in the feedback loop of the log amp.

The log amp is best configured to have a unity gain frequency below 10MHz or even below 2MHz. The feedback capacitance is best chosen to be in the range of 1 to 100 pF.

The topology offers possibility to measure very high resistive sensors/resistors. Namely, when the high resistive sensors are biased with the voltages available in today's modern semiconductor technologies, which are below 5V or even below 2 V, they yield currents in the order of picoampere. This current level is, for instance, the current in the best switches in their off state. In this topology, this current is passed only to the BJT attached to the inverting node of the differential amplifier. Since BJT is preferably the only component attached to the inverting node of the amplifier this means that whole current passes through it. In other words, there is no unwanted leakage or current loss.

This current is then converted into voltage by the BJT's translinear current-to-voltage characteristics. The only limit to the minimum current that can be measured is set only by the minimum current that can be still sensed by the chosen BJT. Today's semiconductor technologies offer BJTs that can sense current in the picoampere range.

According to another aspect of the invention, there is provided a chemical sensor comprising at least one layer of a metal oxide arranged between two electrodes forming a resistive element within a circuit as described above.

The above and other aspects of the present invention together with further advantageous embodiments and applications of the invention are described in further details in the following description and figures.

BRIEF DESCRIPTION OF THE FIGURES

FIG. 1 is a schematic diagram of components of a circuit generating an output proportional to temperature and the logarithm of a scaled sensing resistive element in accordance with an example of the invention;

FIG. 2 illustrates a circuit with a log amp element in an example of the invention;

FIG. 3 shows a variant of the circuit of FIG. 2 with an additional stabilizing/feedback element; and

FIG. 4 illustrates an example of removal of temperature dependency from a circuit as in FIG.1.

DETAILED DESCRIPTION

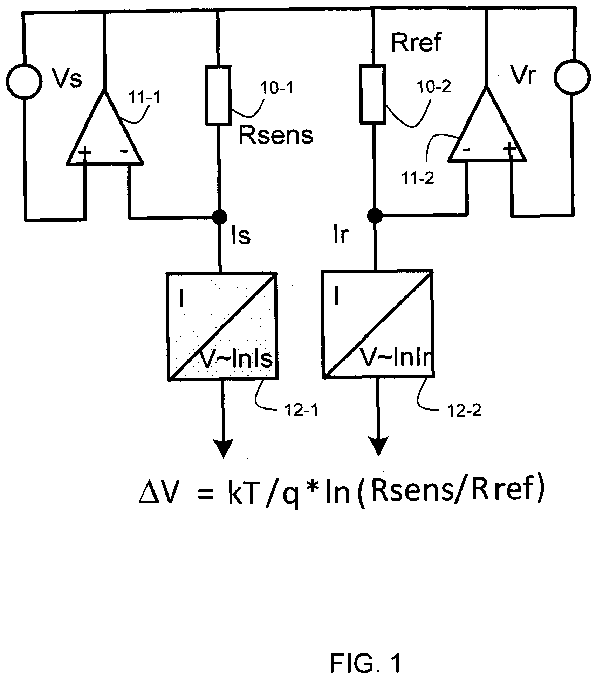

The schematic circuit diagram of FIG. 1 shows a resistive sensing element Rsens 10-1 biased with the sensing voltage Vs and a resistive reference element Rref 10-2 biased with the reference voltage Vr using two voltage buffers 11-1, 11-2 respectively.

The currents Is, Ir through the elements 10-1 and 10-2 are connected to the respective input terminals of two translinear current-to-voltage (I-V) converter circuits 12-1, 12-2. There is no current to the inputs of the buffers 11-1, 11-2 providing sensing voltage Vs and reference voltage Vr. The input current of the sensing translinear converter is given as the ratio of the sensing voltage Vs and the variable sensing resistive element Rsens. The input current of the reference translinear element is given as the ratio of the reference voltage Vr and the reference resistive element Rref.

- It should be noted that the output of the translinear converter will be in general also proportional to the thermal voltage kT/q.

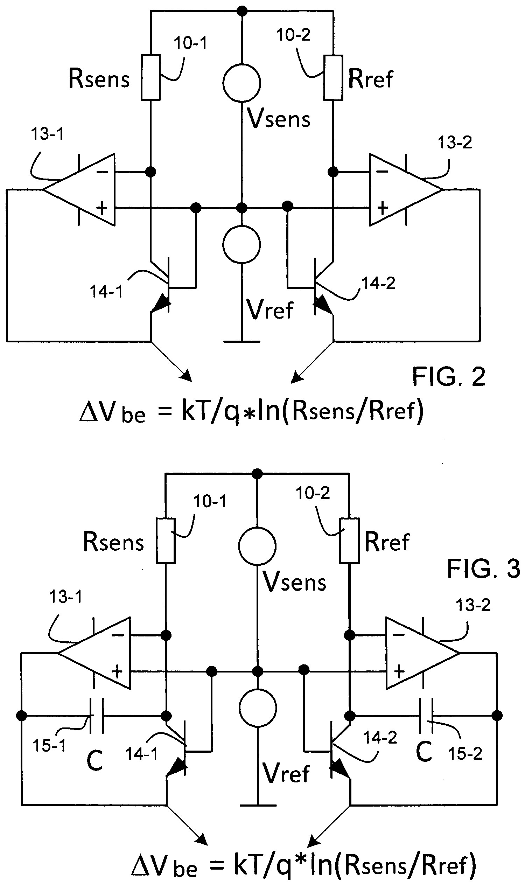

In FIG. 2 the translinear converter and the voltage buffer are represented by a log amp including a combination of a non-linear element connected between input and output terminals of an operational (op) amplifier. The non-linear element in FIG.2 is a bipolar transistor, which can be of npn or pnp -type. One terminal of Rsens 10-1 and hence the sensing current Is is connected to the inverting input terminal of a first op amplifier 13-1 and the collector terminal of a first transistor 14-1. The output terminal of the first op amplifier 13-1 is connected to the emitter terminal of the transistor 14-1. The voltages generated by the log amp are the base-emitter voltage Vbe of the transistors.

A terminal of Rref and hence the reference current Ir is connected in the same way to a second op amplifier 13-2 and a second transistor 14-2.

The non-inverting inputs of the op amplifiers 13-1, 13-2 are connected to a (common) reference voltage Vref. The choice of Vref is a trade-off between the highest output swing that can be processed and the need to deliver the highest possible current to the sensing element Rsens 10-1 for better signal-to-noise ratio. The reference voltage Vref should be stable and temperature independent. As an example a voltage divider with a common voltage supply Vdd as input voltage can be a sufficient solution.

The following section of the description provides an example for conditions under which the above described circuits generate a signal proportional to the logarithm of the resistance of Rsens scaled with the resistance of Rref.

The "differential" architecture containing the main and the reference logarithmic amplifiers is shown in Fig. 2. The outputs of the main and reference logarithmic amplifiers are as follows:

$$V_{OUT1} = V_{REF} - V_{BE} = V_{REF} - V_T \ln \frac{I_{sens}}{I_S \left(1 + \frac{V_{CE}}{V_A}\right)}$$

(1)

$$V_{OUT2} = V_{REF} - V_{BEREF} = V_{REF} - V_T \ln \frac{I_{REF}}{I_S \left(1 + \frac{V_{CEREF}}{V_A}\right)},$$

(2)

where $V_{REF}$ is the reference voltage, $V_T = kT/q$ is thermal voltage, $V_{CE}$ and $V_{CEREF}$ are collector-emitter voltages of the BJTs in the main and reference logarithmic amplifiers, respectively, $I_{sens}$ is the current in the resistive sensing element Rsens, $I_{REF}$ is the current in the resistive reference element, and $V_A$ is the Early voltage.

The outputs of the main and reference logarithmic amplifiers can be subtracted in, for instance, an instrumentation amplifier. Its output is proportional to the logarithm of the scaled sensor's current:

$$V_{OUT1} - V_{OUT2} = V_T \ln \frac{I_{REF}\left(1 + \frac{V_{CE}}{V_A}\right)}{I_{sens}\left(1 + \frac{V_{CEREF}}{V_A}\right)},$$

(3)

In this way the saturation current and its temperature dependence are eliminated from the expression for the sensor's resistance. The output voltage is proportional to temperature, (we exclude this since we propose cancellation of the temperature dependence in the ADC).The output can be transformed into an output proportional to the logarithm of the scaled sensor's resistance, considering that the current in the resistive sensing element and the current in the resistive reference element are given by, respectively:

$$I_{sens} = \frac{V_{DD} - V_{REF} - V_{off}}{R_{sens}},$$

(4)

$$I_{REF} = \frac{V_{DD} - V_{REF} - V_{offREF}}{R_{REF}},$$

(5)

where $V_{off}$ and $V_{offREF}$ comprise both the offset voltage of the logarithmic amplifiers and its gain error.

Combining the equations (4) and (5) into (3) yields:

$$V_{OUT} = V_T \ln \frac{\frac{V_{DD} - V_{REF} - V_{offREF}}{R_{REF}}\left(1 + \frac{V_{CE}}{V_A}\right)}{\frac{V_{DD} - V_{REF} - V_{off}}{R_{sens}}\left(1 + \frac{V_{CEREF}}{V_A}\right)}.$$

(6)

The equation (6) can be further simplified to:

$$V_{OUT} = V_T \ln \frac{R_{sens}\left(1 - \frac{V_{offREF}}{V_{DD} - V_{REF}}\right)\left(1 + \frac{V_{CE}}{V_A}\right)}{R_{REF}\left(1 - \frac{V_{off}}{V_{DD} - V_{REF}}\right)\left(1 + \frac{V_{CEREF}}{V_A}\right)}.$$

(7)

The offset voltages $V_{off}$ and $V_{offREF}$ can be easily designed to be at least an order of magnitude smaller than the voltage drop on the resistive sensing and reference elements $V_{DD} - V_{REF}$ (Note: the offset voltage of the amplifier can be easily designed to be as low as $\pm$ 10 mV in today's industrial semiconductors technologies ). The same is true for the maximum collector-emitter voltage drops $V_{CE}$ and $V_{CEREF}$ with respect to the Early voltage of BJTs in some of today's semiconductors technologies. The Early voltage can range from few tens of volts to few hundred of volt. As a consequence, the terms *1/(1+x)* of Eq. (7) can be approximated by *1-x* and the equation (7) finally becomes:

$$V_{OUT} = V_T \ln\left[\frac{R_{sens}}{R_{REF}}\left(1 - \frac{V_{offREF}V_{off}}{(V_{DD}-V_{REF})^2}\right)\left(1 - \frac{V_{CE}V_{CEREF}}{V_A^2}\right)\right],$$

$$V_{OUT} = V_T \ln\frac{R_{sens}}{R_{REF}} + V_T \ln\left[\left(1 - \frac{V_{offREF}V_{off}}{(V_{DD}-V_{REF})^2}\right)\left(1 - \frac{V_{CE}V_{CEREF}}{V_A^2}\right)\right].$$

(8)

In Eq. (8) the worst case value for the offset-related error for the overestimated offsets of the amplifiers $V_{offREF}=V_{off} = 10mV$ and the voltage drop on the sensing resistive element equal to the voltage drop on the reference resistive element VR=VS=$V_{DD}$ - $V_{REF}$= 0.9 V is:

$$\frac{V_{offREF}V_{off}}{(V_{DD}-V_{REF})^2} = 1.234 \cdot 10^{-4} ,$$

(9)

while the error due to the finite output resistance for the NPN transistor with approximation of the Early voltage at 50V is:

$$\frac{V_{CE}V_{CEREF}}{V_{A\_NPN}^2} = 2.77 \cdot 10^{-4} ,$$

(10)

where

$$V_{CE\_max}=V_{CEREF\_max} = 0.9\ V.$$

Taking into account the relations (9) to (10), Eq. (8) can be further simplified to:

$$V_{OUT} = V_T \ln\frac{R_{sens}}{R_{REF}}\left(1 - \frac{V_{offREF}V_{off}}{(V_{DD}-V_{REF})^2}\frac{1}{\ln\frac{R_{sens}}{R_{REF}}} - \frac{V_{CE}V_{CEREF}}{V_A^2}\frac{1}{\ln\frac{R_{sens}}{R_{REF}}}\right).$$

(11)

The terms in the brackets are again on the order of $10^{-5}$ and can be completely neglected to leave only:

$$V_{OUT} = V_T \ln\frac{R_{sens}}{R_{REF}} .$$

(12)

The reference resistor Rref should be stable and temperature independent. The choice depends on the method of manufacturing the semiconductor circuit. For example, there are technologies that offer poly resistors with temperature coefficients going as low as few hundreds of ppm/°C over 100°C t The matching of the two BJT transistors in the main and reference amplifiers is necessary for the output voltage to be proportional to the natural logarithm of the scaled sensing resistive element. The translinear components as used herein are best stabilized through a feedback. Thus FIG: 3 shows a stabilized variant of the circuit of FIG. 2. The same numerals are used to denote indentical elements as they appear inboth figures.

The feedback loop is implemented through a capacitance 15-1, 15-2 of 10 pF between the output terminals of the op amplifiers 13-1, 13-2 and the collector terminal of the transistors 14-1,14-2. Again the feedback is introduced in identical manner in both the sensing and the reference circuit.

The function of the feedback capacitors 15-1, 15-2 is twofold: Firstly, it offers stabilization of the feedback loop with the differential amplifier having much lower bandwidth as compared with the case when no feedback capacitor is present. Thus when used it allows the main amplifier to have the unity gain frequency as low as 1.6Mhz.

Secondly, the capacitor filters out white noise of the resistive sensor/resistor Rsens 10-1, which is especially important for high values of the resistances of the resistive sensors.

In the case of high values of the resistive sensors the current through the transistor is very low. This in turn means that the transconductance gm of the BJT is very low. The power spectral density PSD of the output noise of the circuit without feedback capacitor 15-1,15-2 is proportional to 1/gm, which leads to increase in RMS noise with the increase of the resistance. Since the useful signal - current in the resistive sensor/resistor Rsens decreases with the increase of the resistance, then the SNR decreases for high values of the resistors. This in turn means that the resolution degrades for high values of the resistors. The addition of the capacitor 15-1, 15-2 adds a bandwidth limiting pole proportional to the gm of the BJT. Thus, the amplitude of the output PSD is proportional to the resistance value R (strictly speaking sqrt(R)) due to thermal noise of the resistor, but the bandwidth of the circuit is inversely proportional to R. In this way the RMS value of the output noise is determined only by the kT/C noise.

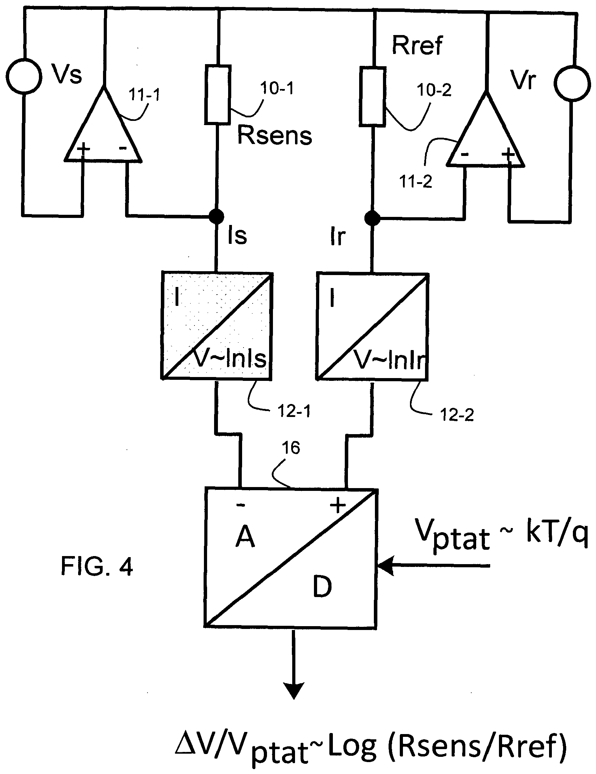

As noted above the difference between the base-emitter voltages Vbe of the sensing and the reference branch of the circuit is not only proportional to the logarithm of the scaled resistance, i.e. ~ ln(Rsens/Rref) but also proportional to the thermal voltage kT/q. In the known log amp circuits the temperature compensation is usually provided in the analog part of the circuit using for example an additional PTAT (proportional to absolute temperature) current Iptat. Whilst these known methods can be applied to the above circuits, the temperature dependence can be also removed on the system level by using an analog to digital converter ADC 16 with a reference voltage proportional to the absolute temperature Vptat ~kT/q as illustrated in FIG. 4. The output of the ADC is thus temperature independent. The change means that the signal proportional to the temperature is carried through all analogue stages of the circuit and is only removed as the signal is passed to the digital part of the circuit.

Some of the embodiments disclosed in this patent application have been described with specific signals implemented as current-mode or voltage mode signals, but the inventive principles also contemplate other types of signals, whether characterized as voltages or currents. Likewise, some semiconductor devices are described as being specifically NPN or PNP BJTs, but in many cases different polarities or different device types such as J-FETs or CMOS transistors can also be utilized.

A device referred to as a "log amplifier" discussed herein has been shown as including a bipolar junction transistor (BJT) because these are particularly well suited for use in logarithmic circuits, offering very close logarithmic law conformance over a range of at least eight decades of current. However, the inventive principles of this application are not necessarily limited to log transistors. Therefore, the term "log amplifier" as used herein means not only to include a BJT, but any type of log-responding device such as might be possible with MOS transistors operated in the sub-threshold region. This may, for example, be necessary when BJTs are not available in an integrated circuit process, and operation over only a smaller current range is required.

The "base" of a log transistor therefore refers to the control terminal of any translinear device, the "collector" refers to the terminal to which the input current is applied, and the "emitter" refers to the terminal that is grounded as that term is understood within the context of the present application. A translinear device is one exhibiting an essentially exponential relationship between the current in its output terminal and the voltage applied to its control terminal, so called because its transconductance is a linear function of the current in its output terminal.

While there are shown and described presently preferred embodiments of the invention, it is to be understood that the invention is not limited thereto but may be otherwise variously embodied and practised within the scope of the following claims.

**Claims**

1. A resistive sensor comprising a resistive sensing element (Rsens, 10-1) biased with a sensing voltage (Vs), a resistive reference element (Rref,10-2) biased with a reference voltage (Vr), with a terminal of said resistive sensing element connected to an input terminal of a sensing translinear current-voltage converter (12-1) and with a terminal of said resistive reference element connected to an input terminal of a reference translinear current-voltage converter (12-2), with a difference voltage signal between an output terminal of said sensing translinear current-voltage converter and an output terminal of said reference translinear current-voltage converter being a voltage (ΔVbe) proportional to the absolute temperature and the logarithm of the resistance of the resistive sensing element (Rsens,10-1) scaled with the resistance of the reference resistive element (Rref,10-2), wherein the converters (12-1,12-2) are logarithmic amplifiers comprising an operational amplifier (13-1,13-2) and a bipolar transistor (14-1,14-2) and wherein the resistive sensing element (Rsens,10-1) and the transistor (14-1) are the sole elements connected to one of the input terminals of the operational amplifier (13-1), such that essentially all of the current (Is) through the resistive sensing element(Rsens,10-1) passes through the transistor (14-1).

2. The resistive sensor of claim 1, further comprising an analog-to-digital converter (16) receiving as input a difference signal proportional to a difference voltage signal between an output terminal of said sensing translinear current-voltage converter (12-1) and an output terminal of said reference translinear current-voltage converter (12-1) and as reference voltage a voltage (Vptat) proportional to the absolute temperature voltage generating a digital output representative of the logarithm of the resistance of the resistive sensing element(Rsens,10-1) scaled by the resistance of the resistive reference element (Rref,10-2) with the proportionality to the absolute temperature voltage removed.

3. The resistive sensor according to claim 1 or 2, wherein the biasing sensing voltage (Vs) and reference voltages (Vr) are equal.

4. The resistive sensor according to claim 1, wherein output terminal of the operational amplifier is connected to the emitter of the bipolar transistor.

5. The resistive sensor of any of the preceding claims, wherein the converter (12-1) is stabilized using a feedback.

6. The resistive sensor of any of the preceding claims, wherein the feedback includes a capacitance (15-1,15-2) or a capacitance and a resistor between the output terminal of the operational amplifier (13-1,13-2) and collector terminal of the transistor (14-1,14-2).

7. A chemical sensor comprising a resistive sensor according to any of the preceding claims, wherein the resistive sensing element comprises at least one layer of a metal oxide arranged between two electrodes.


**Patentansprüche**

1. Ein Widerstandssensor, umfassend ein resistives Sensorelement (Rsens, 10-1) das mit einer Messspannung (Vs) beaufschlagt ist, ein resistives Referenzelement (Rref, 10-2) das mit einer Referenzspannung (Vr) beaufschlagt ist, wobei ein Anschluss des resistiven Sensorelements mit einem Eingang eines detektierenden translinearen Strom-Spannung-Wandlers (12-1) verbunden ist und wobei ein Anschluss des resistiven Referenzelements mit einem Eingang eines translinearen Referenz-Strom-Spannung-Wandlers (12-2) verbunden ist, wobei ein Differenzspannungssignal zwischen einem Ausgang des detektierenden translinearen Strom-Spannung-Wandlers und einem Ausgang des translinearen Referenz-Strom-Spannung-Wandlers eine Spannung (ΔVbe) ist, die proportional zur absoluten Temperatur und dem Logarithmus des Widerstands des mit dem Widerstand des resistiven Referenzelements (Rref, 10-2) skalierten resistiven Sensorelements (Rsens, 10-1) ist, wobei die Wandler (12-1, 12-2) logarithmische Verstärker sind, die einen Operationsverstärker (13-1, 13-2) und einen Bipolartransistor (14-1, 14-2) umfassen und wobei das resistive Sensorelement (Rsens, 10-1) und der Transistor (14-1) die einzigen Elemente sind, die mit einem der Eingänge des Operationsverstärkers (13-1) verbunden sind, derart dass im Wesentlichen alle Ströme (Is) durch das resistive Sensorelement (Rsens, 10-1) durch den Transistor (14-1) fliessen.

2. Der Widerstandssensor nach Anspruch 1, weiter umfassend einen Analog-Digital-Wandler (16), der als Eingang ein Differenzsignal empfängt, das proportional zu einem Differenzspannungssignal zwischen einem Ausgang des detektierenden translinearen Strom-Spannung-Wandlers (12-1) und einem Ausgang des translinearen Referenz-Strom-Spannung-Wandlers (12-2) ist, und als Referenzspannung eine Spannung (Vptat) die zur absoluten Temperaturspannung proportional ist, die eine Digitalausgabe generiert, welche ein Mass für den Logarithmus des Widerstands des resistiven Sensorelements (Rsens, 10-1), das mit dem Widerstand des resistiven Referenzelements (Rref, 10-2) skaliert ist, wobei die Proportionalität der absoluten Temperaturspannung entfernt wurde, darstellt.

3. Der Widerstandssensor nach Anspruch 1 oder 2, wobei die beaufschlagende Messspannung (Vs) und die Referenzspannungen (Vr) gleich sind.

4. Der Widerstandssensor nach Anspruch 1, wobei der Ausgang des Operationsverstärkers mit dem Emitter des Bipolartransistors verbunden ist.

5. Der Widerstandssensor nach einem der vorangehenden Ansprüche, wobei der Wandler (12-1) mittels einer Rückkopplung stabilisiert ist.

6. Der Widerstandssensor nach einem der vorangehenden Ansprüche, wobei die Rückkopplung einen Kondensator (15-1, 15-2) oder einen Kondensator und einen Widerstand zwischen dem Ausgang des Operationsverstärkers (13-1, 13-2) und dem Kollektor des Transistors (14-1, 14-2) einschliesst.

7.  Ein chemischer Sensor umfassend einen Widerstandssensor nach einem der vorangehenden Ansprüche, wobei das resistive Sensorelement mindestens eine Schicht eines Metalloxids, das zwischen zwei Elektroden angeordnet ist, umfasst.

## Revendications

1.  Un capteur résistif, comprenant un élément de détection résistif (Rsens, 10-1) polarisée avec une tension de détection (Vs), un élément de référence résistif (Rref, 10-2) polarisée avec une tension de référence (Vr), une borne dudit élément de détection résistif étant connectée avec une borne d'entrée d'un convertisseur courant-tension de détection translinéaire (12-1) et une borne dudit élément de référence résistif étant connectée avec une borne d'entrée d'un convertisseur courant-tension de référence translinéaire (12-2), un signal de tension différentielle entre une borne de sortie dudit convertisseur courant-tension de détection translinéaire et une borne de sortie dudit convertisseur courant-tension de référence translinéaire étant une tension ($\Delta$Vbe) proportionnelle avec la température absolue et le logarithme de la résistance de l'élément de détection résistif (Rsens, 10-1), mis à l'échelle avec la résistance de l'élément de référence résistif (Rref, 10-2), les convertisseurs (12-1, 12-2) étant des amplificateurs logarithmiques comprenant un amplificateur opérationnel (13-1, 13-2) et un transistor bipolaire (14-1, 14-2) et l'élément de détection résistif (Rref, 10-1) et le transistor (14-1) étant les seuls éléments connectés avec une des bornes d'entrée de l'amplificateur opérationnel (13-1), de sorte qu'essentiellement tous les courants (Is) à travers l'élément de détection résistif (Rref, 10-1) passe à travers le transistor (14-1).

2.  Le capteur résistif selon la revendication 1, comprenant en outre un convertisseur analog-digital (16) qui reçoit comme entrée un signal de différence proportionnel avec un signal de tension différentielle entre une borne de sortie dudit convertisseur courant-tension de détection translinéaire (12-1) et une borne de sortie dudit convertisseur courant-tension de référence translinéaire (12-2) et comme tension de référence une tension (Vptat) proportionnelle avec la tension de température absolue qui génère une sortie digitale représentant le logarithme de la résistance de l'élément de détection résistif (Rsens, 10-1), mis à l'échelle avec la résistance de l'élément de référence résistif (Rref, 10-2) avec la proportionnalité avec la tension de température absolue enlevée.

3.  Le capteur résistif selon la revendication 1 ou 2), la tension de référence (Vr) polarisante et les tensions de référence (Vr) étant égales.

4.  Le capteur résistif selon la revendication 1, la borne de sortie de l'amplificateur opérationnel étant connectée avec l'émetteur du transistor bipolaire.

5.  Le capteur résistif selon l'une des revendications précédentes, le convertisseur (12-1) étant stabilisé en utilisant une boucle de rétroaction.

6.  Le capteur résistif selon l'une des revendications précédentes, la boucle de rétroaction incluant une capacité (15-1, 15-2) ou une capacité et une résistance entre la borne de sortie de l'amplificateur opérationnel (13-1, 13-2) et la borne de collecteur du transistor (14-1, 14-2).

7.  Un capteur chimique comprenant un capteur résistif selon l'une des revendications précédentes, l'élément de détection résistif comprenant au moins une couche d'oxyde de métal arrangée entre deux électrodes.

$$\Delta V = kT/q * \ln(Rsens/Rref)$$

FIG. 1

FIG. 2

$$\Delta V_{be} = kT/q * \ln(R_{sens}/R_{ref})$$

FIG. 3

$$\Delta V_{be} = kT/q * \ln(R_{sens}/R_{ref})$$

Vs  11-1  10-1  Rsens  Rref  10-2  Vr  11-2

Is  Ir

I  V~lnIs  12-1

I  V~lnIr  12-2

16

− A +  D  $V_{ptat} \sim kT/q$

FIG. 4

$\Delta V / V_{ptat} \sim Log\ (Rsens/Rref)$

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7310656 B
- US 4604532 A
- US 5677561 A
- US 8207776 B

**Non-patent literature cited in the description**

- **M. GRAF.** Metal Oxide Monolithic Complementary Oxide Semiconductor Gas Sensor Microsystem. *Anal. Chem.,* 2004, 4437-4445
- **U. FREY et al.** A Digital CMOS Architecture for a Micro-Hotplate Array. *IEEE Journal of Solid State Circuits,* February 2007, vol. 42 (2), 441-450
- A Smart Single-Chip Micro-Hotplate-Based Gas Sensor System in CMOS-Technology. DIEGO BARRETTINO ET AL, ANALOG INTEGRATED CIRCUITS AND SIGNAL PROCESSING. KLUWER ACADEMIC PUBLISHERS, 01 June 2004, vol. 39, 275-287